# EUROPÄISCHE PATENTSCHRIFT

(11) **EP 1 782 080 B1**
(45) Veröffentlichungstag und Bekanntmachung des Hinweises auf die Patenterteilung: **09.04.2008**
(21) Anmeldenummer: 05775973.0
(22) Anmeldetag: 12.08.2005
(51) Int. Cl.: G01R 15/14, G01R 15/06, H02J 17/00

(54) **ANORDNUNG ZUR ELEKTRISCHEN ENERGIEVERSORGUNG EINES MESSGERÄTES**
ASSEMBLY FOR SUPPLYING ELECTRIC ENERGY TO A MEASURING DEVICE
ENSEMBLE POUR L'ALIMENTATION ELECTRIQUE D'UN APPAREIL DE MESURE

(30) Priorität: 24.08.2004 DE 102004041091; 18.07.2005 DE 102005033451
(43) Veröffentlichungstag der Anmeldung: 09.05.2007
(73) Patentinhaber: SIEMENS AKTIENGESELLSCHAFT, 80333 München (DE)
(72) Erfinder: BIRKLE, Siegfried, 91315 Höchstadt (DE); HAIN, Stefan, 91090 Effeltrich (DE)
(86) Internationale Anmeldenummer: PCT/EP2005/053971
(87) Internationale Veröffentlichungsnummer: WO 2006/021521

(56) Entgegenhaltungen:
- DE-A1- 2 911 476
- DE-A1- 10 213 845
- DE-C- 910 925

## Beschreibung

Die Erfindung betrifft eine Anordnung zum Versorgen eines auf Hochspannungspotenzial angeordneten elektrischen Messgeräts mit elektrischer Energie.

In Hochspannungsanlagen ist es für Schutz- und Messzwecke notwendig, den Strom im auf Hochspannungspotential befindlichen Leiter zu messen. Aus Kostengründen und für eine störsichere Datenübertragung hat es sich als vorteilhaft erwiesen, das Signal eines Stromwandlers noch auf Hochspannungspotential zu digitalisieren, und das Messsignal mit Lichtwellenleitern zur Weiterverarbeitung auf Erdpotential zu übertragen. Dazu muss jedoch die auf Hochspannungspotential befindliche Elektronik mit Hilfsenergie versorgt werden. Ebenfalls für Schutz- und Messzwecke ist es notwendig, die elektrische Spannung des Leiters zu messen. Dazu werden derzeit getrennte Strom- und Spannungswandler aufgestellt, wobei Kosten und Installationsaufwand für zwei Geräte anfallen.

In *"*Sensors and Actuators A", Band 25 bis 27 (1991), Seiten 475 bis 480 ist eine Anordnung beschrieben, bei der Licht einer Lichtquelle, hier einer Laserdiode, zu einem photoelektrischen Wandler übertragen wird und dort in elektrische Energie umgewandelt wird. Letztere dient der Versorgung eines Sensors. Die Messdaten des Sensors werden ebenfalls optisch über einen Lichtwellenleiter übertragen. Aufgrund der verwendeten Spezialkomponenten insbesondere des leistungsstarken Lasers, des photoelektrischen Wandlers und auch der optischen Steckverbindungen ist dieses Versorgungssystem jedoch mit einem nicht unerheblichen Aufwand und Kosten verbunden.

Bei der in der DE 910 925 angegebenen Anordnung zur Regelung der Ansteuerung von Gas- oder Dampfentladungsstrecken wird ein hochfrequentes Signal mittels kapazitiver Komponenten übertragen. Es sind ein erster kapazitiver Teilzweig für die Vorwärtsrichtung und ein zweiter kapazitiver Teilzweig für die Rückwärtsrichtung vorgesehen. Das hochfrequente Signal dient allerdings nicht der Energieversorgung, sondern vielmehr der Steuerung einer auf Hochspannungspotential angeordneten Zündschaltung.

In DE 29 11 476 A1 wird eine Anordnung angegeben, die zwei Kondensatorstränge nutzt, um Hilfsenergie kapazitiv auf ein Hochspannungspotential zu übertragen. Gleichzeitig wird am Kondensatorfuß ein kapazitiver Teiler zur Spannungsmessung aufgebaut. Die Aufgabe der Querdrosseln ist es, den Hochfrequenzgenerator von der Blindleistungsbereitstellung zu entlasten und zwischen benachbarten Kondensatoren auftretende Isolationsdifferenzen auszugleichen. Durch die Vielzahl der benötigten Einzelkomponenten ist die Anordnung jedoch aufwendig in der Realisierung. Ist darüber hinaus mit dieser Anordnung die Erfassung von Strom- und Spannung beabsichtigt, müssen zwei getrennte Messelektronikbaugruppen vorgesehen werden.

Der Erfindung liegt nun die Aufgabe zugrunde, eine Anordnung zum Versorgen eines auf Hochspannungspotenzial angeordneten elektrischen Messgeräts mit elektrischer Energie anzugeben, die eine möglichst einfache Energieversorgung gewährleistet und gleichzeitig eine Platz- und Materialersparnis ermöglicht.

Zur Lösung der Aufgabe wird eine Anordnung zum Versorgen eines auf Hochspannungspotenzial angeordneten elektrischen Messgeräts mit elektrischer Energie entsprechend den Merkmalen des unabhängigen Patentanspruchs 1 angegeben.

Die erfindungsgemäße Anordnung zum Versorgen eines auf Hochspannungspotenzial angeordneten elektrischen Messgeräts mit elektrischer Energie umfasst mindestens:
- einen ersten, erdpotenzialseitigen Transformator, der
   - eine Primärseite aufweist, an welche ein Generator zur Erzeugung eines energieversorgenden Speisesignals angeschlossen ist, und
   - eine symmetrisch unterteilte Sekundärseite aufweist, deren Unterteilungsstelle auf Erdpotenzial gelegt ist,
- einen zweiten, hochspannungspotenzialseitigen Transformator, der
   - eine symmetrisch unterteilte Primärseite aufweist, deren Unterteilungsstelle auf das Hochspannungspotenzial gelegt ist, und
   - eine Sekundärseite aufweist, an die das Messgerät zur Energieversorgung anzuschließen ist,
   und
- ein symmetrisch aufgebautes potenzialabbauendes Übertragungsglied, das
   - zwei parallele Teilzweige aufweist, die zwischen der Sekundärseite des ersten Transformators und der Primärseite des zweiten Transformators verlaufen,
   - jeweils zur Spannungsteilung mindestens zwei Spannungsteilermittel mit dazwischenliegendem Knotenpunkt aufweisen,
      und
   - über beide Knotenpunkte über jeweils eine Leitung mit dem Messgerät zu einer Spannungsmessung zu verbinden ist.

Die Erfindung beruht dabei auf der Erkenntnis, dass bei einer Zusammenführung zweier Leitungen, die jeweils ein symmetriertes Signal führen, sich die symmetrierten Signale aufgrund ihrer gegenphasigen Phasenlage gegenseitig aufheben. Mit der von beiden Teilzweigen ausgebildeten zweigeteilte Übertragungsstrecke ist es somit möglich, ein auf Hochspannungspotenzial angeordnetes Messgerät mit einem Speisesignal, das von einem auf Erdpotential angeordneten Generator erzeugt wird, zu betreiben und gleichzeitig eine Spannungsmessung, bei der die Spannung an den beiden Teilzweigen abgegriffen wird, vorzunehmen, ohne dass diese vom Speisesignal gestört wird.

Vorteilhafte Ausgestaltungen des Sensorrads gemäß der Erfindung ergeben sich aus den von Anspruch 1 abhängigen Ansprüchen.

Es ist insbesondere vorteilhaft, dass das Messgerät zum Ermitteln eines elektrischen Stromes und einer elektrischen Spannung ausgelegt ist. Somit befinden sich alle Teile des Spannungsteilers in einem Gehäuse und werden gleichartig hergestellt. Ein möglicherweise vorhandener Temperaturgang der Komponenten hebt sich damit idealerweise auf. Zudem wird nur eine Messwerterfassungselektronik benötigt

Weiter ist vorteilhaft, dass der Generator derart leistungsarm ausgelegt ist, dass dem Messgerät mittels eines Speisesignals eine elektrische Leistung von höchstens 100 mW zuführbar ist. Die erfindungsgemäße Anordnung benötigt somit keine Querdrosseln. Durch einen niedrigen Hilfsenergieverbrauch der Messelektronik kann die Amplitude und Frequenz der Speisespannung niedrig gehalten werden. Damit kann mit geringem technischen Aufwand die Speisespannungsquelle die Blindleistung für die Kondensatoren liefern. Der Einbau und die Kontaktierung der Querdrosseln in einen Hochspannungskondensator sind nämlich aufwendig und verhindern eine weitere Fertigungsvereinfachung der Kondensatoren. Zudem werden für Wechselspannungsanwendungen neben den Kondensatoren keine zusätzlichen Bauelemente im Hochspannungszweig benötigt. Der Kondensator lässt sich damit wie ein herkömmlicher Steuerkondensator fertigen, der in großen Stückzahlen hergestellt werden kann.

Vorzugsweise sind die beiden Teilzweige eng benachbart zueinander angeordnet. Dadurch sinkt der Platzbedarf der Anordnung. Außerdem verhindert die enge räumliche Nachbarschaft beider Teilzweige, dass eine an sich unerwünschte Abstrahlung von Speiseenergie erfolgt. Die beiden jeweils für die Vorwärts- oder Rückwärtsrichtung bestimmten Teilzweige wirken ähnlich wie eine bifilare Leiteranordnung, bei der sich eine wechselseitige Kompensation des Abstrahlverhaltens einstellt.

Es ist von Vorteil, dass die beiden Teilzweige nebeneinander in einem Isolator angeordnet sind. Dadurch werden die Kosten für die Spannungs-Isolierung der beiden Teilzweige reduziert, denn es kann zumindest ein gemeinsames Isolatorgehäuse verwendet werden.

Insbesondere weist das Speisesignal eine Speisefrequenz zwischen 1 kHz und 1 MHz auf. In diesem Frequenzbereich kann eine Abstrahlung von Speiseenergie gut unterbunden werden. Außerdem ist die genannte Untergrenze weit genug von einer in Einrichtungen der öffentlichen Energieversorgung eingesetzten Netzfrequenz (DC oder 50 Hz oder 60 Hz) sowie von deren für Mess- und Auswertungszwecke gegebenenfalls relevanten Oberwellen entfernt, so dass eine Beeinflussung ausgeschlossen werden kann.

Es ist insbesondere vorteilhaft, dass eine zusätzliche, insbesondere optische, Übertragungsstrecke zur Übertragung eines vom Messgerät ermittelten Messsignals vorgesehen ist. Dadurch wird eine besonders gute Trennung zwischen Speise- und Messsignal erreicht.

Weiter ist vorteilhaft, dass die mindestens zwei Spannungsteilermittel des jeweiligen Teilzweiges mindestens zwei Kapazitäten sind. Somit lässt sich auf besonders einfache und kostengünstige Weise ein Spannungsteiler aufbauen.

Es ist von Vorteil, dass die mindestens zwei Spannungsteilermittel des jeweiligen Teilzweiges mindestens zwei Parallelschaltungen aus mindestens einer Kapazität und mindestens einem Widerstand sind. Damit lässt sich die erfindungsgemäße Anordnung sowohl in Gleich- als auch in Wechselspannungsanlagen einsetzten.

Bevorzugte, jedoch keinesfalls einschränkende Ausführungsbeispiele der Erfindung werden nunmehr anhand der Zeichnung näher erläutert. Zur Verdeutlichung ist die Zeichnung nicht maßstäblich ausgeführt, und gewisse Merkmale sind nur schematisiert dargestellt. Im Einzelnen zeigen
- Figur 1: eine Anordnung zum Versorgen eines auf Hochspannungspotenzial angeordneten elektrischen Strom- und Spannungsmessgeräts mit elektrischer Energie für den Einsatz in Wechselspannungsanlagen und
- Figur 2: eine Anordnung zum Versorgen eines auf Hochspannungspotenzial angeordneten elektrischen Strom- und Spannungsmessgeräts mit elektrischer Energie für den Einsatz sowohl in Gleich- als auch in Wechselspannungsanlagen.

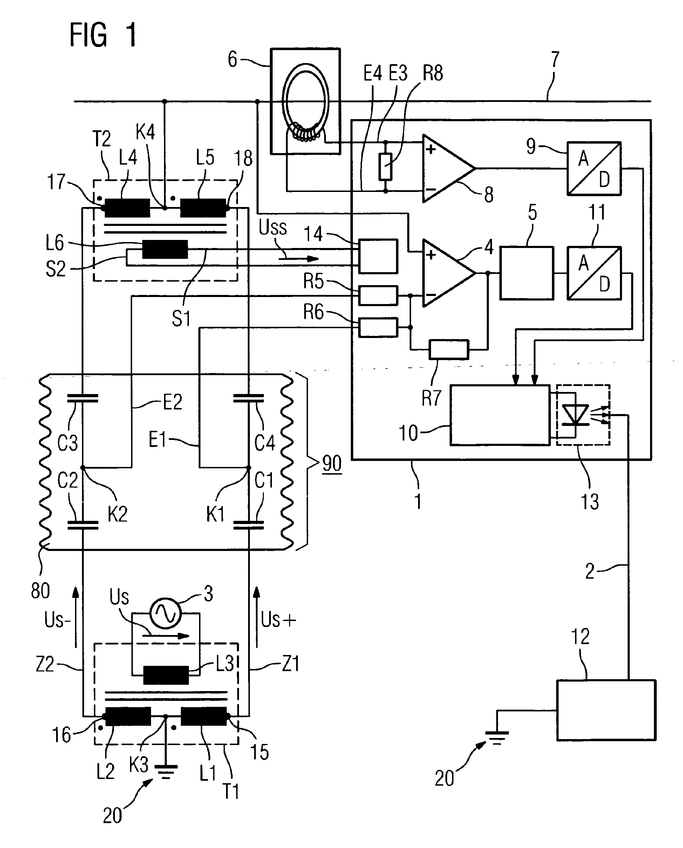

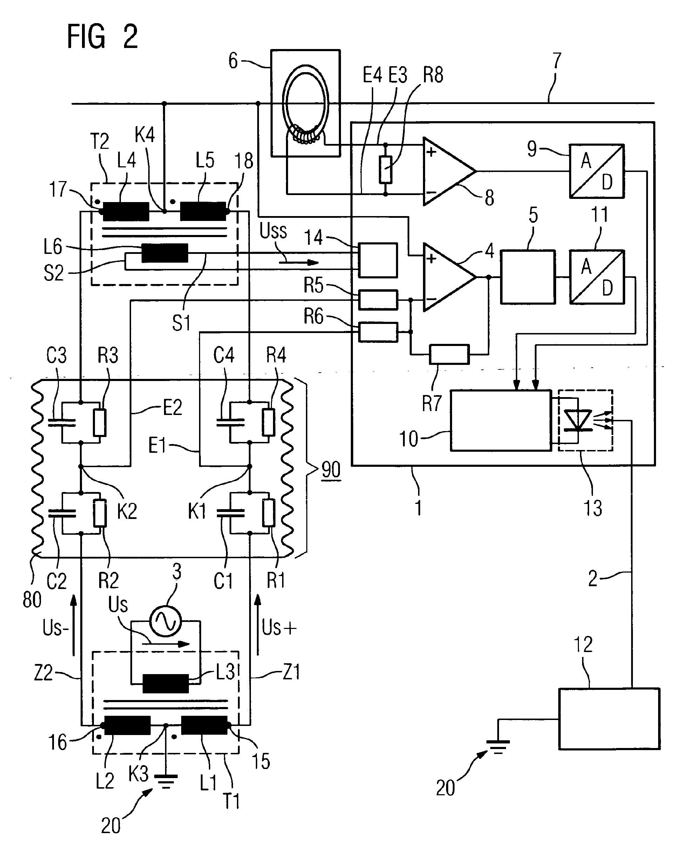

Einander entsprechende Teile sind in den Figuren 1 und 2 mit denselben Bezugszeichen versehen.

In Figur 1 ist ein Ausführungsbeispiel für eine Anordnung zum Versorgen eines auf Hochspannungspotenzial angeordneten elektrischen Strom- und Spannungsmessgeräts 1 mit elektrischer Energie dargestellt. Das symmetrisch aufgebaute potenzialabbauende Übertragungsglied 90 der Anordnung weist dabei vier Kapazitäten C1 bis C4 auf, die als Spannungsteiler vorgesehen sind. Dabei gilt für die Dimensionierung der Kapazitäten C1 bis C4: C1 = C2 und C3 = C4, wobei die Kapazitäten C3 und C4 den 100-fachen bis 10000-fachen Wert der Kapazitäten C1 und C2 betragen sollten. So sind beispielsweise für die Kapazitäten C1 und C2 Werte von 0,1 nF bis 10 nF denkbar. Dementsprechend müssen die Kapazitäten C3 und C4 einen Wert von 10 nF bis 100 µF annehmen. Der Spannungsabgriff für die Spannungsmessung erfolgt auf Hochspannungspotential an den Knotenpunkten K1 und K2. Die Messelektronik des Messgerätes 1 befindet sich ebenfalls auf Hochspannungspotential und erfasst gleichzeitig Strom- und Spannungswerte, digitalisiert diese und überträgt sie über mindestens einen Lichtwellenleiter 2 auf Erdpotential 20. Die Messelektronik des Messgerätes 1 ist möglichst sparsam im Hilfsenergieverbrauch ausgelegt, so dass insbesondere 100 mW nicht überschritten werden. Die Hilfsenergieversorgung erfolgt über zwei Transformatoren T1 und T2. Die Transformatoren T1 und T2 sind über ihre Anschlüsse 15, 16 und 17, 18 mittels zwei Teilzweige Z1 und Z2 entsprechend miteinander verbunden. Der Transformator T1 umfasst die Induktivitäten L1, L2 und L3, der Transformator T2 die Induktivitäten L4, L5 und L6. Die entsprechenden Induktivitäten L1, L2, L3 bzw. L4, L5, L6 des jeweiligen Transformators T1 bzw. T2 sind vorzugsweise auf einem gemeinsamen Kern angeordnet und somit magnetisch eng miteinander gekoppelt.

Ein vom Generator 3 erzeugte Speisesignal Us, das beispielsweise in einem Frequenzbereich von 1 kHz bis 1 MHz liegen kann und beispielsweise einen Spannungswert von 10 V bis 1 kV aufweisen darf, wird über die Primärseite des Transformators T1 mit der Induktivität L3 dem Transformators T1 zugeführt. Das Speisesignal Us wird an der die beiden Induktivitäten L1 und L2 aufweisenden Sekundärseite des Transformators T1 in ein symmetriertes Speisesignal Us+ und Us- gewandelt. Hierzu ist zwischen den beiden Induktivitäten L1 und L2 eine geerdete Unterteilungsstelle K3 angeordnet. Der zweite Transformator T2 hat eine primärseitige, zwischen den Induktivitäten L4 und L5 angeordnete Unterteilungsstelle K4, die mit einem Hochspannungsleiter 7 verbunden ist. Das der Primärseite des Transformator T2 zugeführte symmetrierte Speisesignal Us+ und Us- führt sekundärseitig im Transformator T2 zu einem Speisesignal Uss. Das Speisesignal wird über zwei mit der Sekundärseite des Transformators T2 verbundene Speiseleitungen S1 und S2 in die Energieversorgungseinheit 14 des Messgeräts 1 eingespeist. Die Sekundärseite des Transformators T2 weist hierbei die Induktivität L6 auf.

Für das symmetrierte Speisesignal Us+ und Us- sind die Induktivitäten L1 und L2 bzw. L4 und L5 in Serie geschaltet und haben daher eine hohe Induktivität von beispielsweise über 1mH. Die Impedanz liegt somit in einem Bereich von beispielsweise 100 Ω bis 10 kΩ. Für die zu messende Hochspannung, die üblicherweise im Frequenzbereich von 0 Hz (Gleichspannung) bis 500 Hz liegen kann, sind die Induktivitäten L1 und L2 bzw. L4 und L5 auf ihrem jeweiligen Kern antiparallel geschaltet und haben damit eine um den Faktor 10 bis 1000 kleinere Induktivität, die in diesem Beispiel zwischen 1 µH und 100 µH betragen kann. Dies hat zur Folge, dass im Bereich der Frequenz der zu messenden Hochspannung eine kleine Impedanz von beispielsweise unter 1 Ω vorliegt. Diese Impedanz ist sehr klein im Verhältnis zur Impedanz der Kapazitäten C1 und C2, so dass der Spannungsabfall an den Induktivitäten L4 und L5 bei der Spannungsmessung vernachlässigt werden kann.

Die Erfassung des Stromwertes der Hochspannungsleitung 7 kann beispielsweise, wie in Figur 1 angedeutet, mit einem induktiven Stromwandler 6 erfolgen. Andere Strommessmethoden, wie zum Beispiel die Strommessung mittels eines Shunts, sind ebenfalls denkbar. Die vom Stromwandler 6 erzeugten Messsignale werden über zwei Leitungen E3 und E4 an einen als Differenzverstärker geschalteten Operationsverstärker 8 übermittelt, wobei die Leitung E3 mit dem nichtinvertierenden Eingang des Operationsverstärkers 8 und die Leitung E4 mit dem invertierenden Eingang des Operationsverstärkers 8 verbunden ist. Ein Widerstand R8, über welchen beide Leitungen E3 und E4 miteinander verbunden sind, ist zudem parallel zu den beiden Eingängen des Operationsverstärkers 8 geschaltet. Der Widerstand R8 hat hierfür insbesondere einen Widerstandswert im Bereich von 10 mΩ bis 100Ω. Der Ausgang des Verstärkers ist mit einem Analog-Digital-Wandler 9 verbunden, der die vom Operationsverstärker 8 gelieferten analogen Signale digitalisiert und an einen Übertragungseinheit 10 weiterleitet.

Zur Spannungsmessung werden die beiden über die Kapazität C3 und die Induktivität L4 bzw. die Kapazität C4 und die Induktivität L5 abfallenden und über die beiden Knotenpunkte K1 und K2 abgegriffenen Spannungen über zwei Leitungen E1 uns E2 dem Messgerät 1 zugeführt und dort mittels eines als Addierer geschalteten weiteren Operationsverstärkers 4 addiert. Dabei sind zum einen der nichtinvertierende Eingang des Operationsverstärkers 4 mit dem Hochspannungsleiter 7 und zum anderen der invertierende Eingang des Operationsverstärkers 4 über den Widerstand R6 mit dem Knoten K1 und über den Widerstand R5 mit dem Knoten K2 verbunden. Darüber hinaus verbindet ein Widerstand R7 den invertierenden Eingang mit dem Ausgang des Operationsverstärkers 4. Der Widerstandswert für die Widerstände R5 und R6 liegt insbesondere im Bereich von 100Ω bis 1 MΩ. Für den Widerstand R7 ist auch ein Widerstandswert im Bereich von 100Ω bis 1 MΩ geeignet. Da das symmetrierte Speisesignal Us+ und das symmetrierte Speisesignal Us- als zwei gegenphasige Signale in den beiden Teilzweigen Z1 und Z2 geführt werden, während die auf die anliegende Hochspannung zurückzuführenden Spannungen in den beiden Teilzweigen Z1 und Z2 gleichphasig sind, heben sich am Ausgang des Addieres bei ideal symmetrischem Aufbau die gegenphasigen Speisesignale auf, während sich die Messspannungsabfälle verdoppeln. Durch Unsymmetrien im Aufbau verbleibende Speisespannungsreste können leicht durch ein Tiefpassfilter 5 entfernt werden, da sich die Frequenzen der Hochspannung und die des Speisesignals um ungefähr eine Größenordnung unterscheiden. Der Ausgang des Tiefpassfilters 5 ist mit einem Analog-Digital-Wandler 11 verbunden, der die vom Tiefpassfilter 5 gelieferten analogen Signale digitalisiert und ebenfalls an die Übertragungseinheit 10 weiterleitet.

Die Übertragungseinheit 10 umfasst eine Lichtquelle 13, insbesondere eine Leuchtdiode, mit der die digitalisierten Strom- und Spannungsmesswerte per Lichtübertragung über einen Lichtwellenleiter 2 an eine vorzugsweise auf Erdpotential 20 angeordnete Auswerteeinheit 12 gesendet werden können.

Das in Figur 2 dargestellte Ausführungsbeispiel entspricht im Wesentlichen dem in Figur 1 gezeigten Ausführungsbeispiel. Es ist jedoch darüber hinaus für den Einsatz in einer Gleichspannungsanlage vorgesehen. Dabei sind die Kapazitäten C1, C2, C3 und C4 im symmetrisch aufgebauten potenzialabbauenden Übertragungsglied 90 um entsprechend parallel geschaltete Widerstände R1, R2, R3 und R4 erweitert, womit ein kompensierter Spannungsteiler entsteht. Die Widerstände R1 und R2 weisen jeweils einen um den Faktor 1000 höheren Wert als die entsprechenden beiden Widerstände R4 und R5 des jeweiligen Teilzweiges Z1 und Z2 auf. Sind die Widerstände von R4 und R3 insbesondere im kΩ-Bereich dimensioniert, so weisen die Widerstände R1 und R2 demnach Widerstandswerte im MΩ-Bereich auf. R1 und R2 sind darüber hinaus insbesondere für eine Leistung von mindestens 10 W ausgelegt.

In Figur 1 und in Figur 2 ist zudem noch zu sehen, dass zur Hochspannungsisolation das Übertragungsglied 90 mit den beiden nebeneinander angeordneten Teilzweige Z1 und Z2 in einem beide Teilzweige Z1, Z2 umfassenden Isolator 80 untergebracht ist.

## Patentansprüche

1. Messanordnung mit einem auf einem Hochspannungspotenzial angeordneten elektrischen Messgerät (1) und einer Energieversorgungsanordnung für das Messgerät, welche Energieversorgungsanordnung folgende Teile umfasst, nämlich mindestens:
- einen ersten, erdpotenzialseitigen Transformator (T1), der
- eine Primärseite aufweist, an welche ein Generator (3) zur Erzeugung eines energieversorgenden Speisesignals (Us) angeschlossen ist, und
- eine symmetrisch unterteilte Sekundärseite aufweist,
- einen zweiten, hochspannungspotenzialseitigen Transformator (T2), der
- eine symmetrisch unterteilte Primärseite aufweist, deren Unterteilungsstelle (K4) auf das Hochspannungspotenzial gelegt ist, und
- eine Sekundärseite aufweist, an die das Messgerät (1) zur Energieversorgung anzuschließen ist,
und
- ein symmetrisch aufgebautes potenzialabbauendes Übertragungsglied (90), das
- zwei parallele Teilzweige (Z1, Z2) aufweist, die zwischen der Sekundärseite des ersten Transformators (T1) und der Primärseite des zweiten Transformators (T2) verlaufen, und
- jeweils zur Spannungsteilung mindestens zwei Spannungsteilermittel (C1, C2, C3, C4, R1; R2, R3, R4) mit dazwischenliegendem Knotenpunkt (K1, K2) aufweisen,
**dadurch gekennzeichnet, dass**
- von den beiden Knotenpunkten (K1, K2) des Übertragungsgliedes (90) ausgehend zwei Leitungen (E1, E2) zur Spannungsmessung zwischen dem Hochspannungspotenzial und den Knotenpunkten (K1, K2) elektrisch zusammengeführt mit dem Messgerät (1) verbunden sind und **dass**
- die Unterteilungsstelle der Sekundärseite des ersten, erdpotentialseitigen Transformators auf Erdpotential gelegt ist.

2. Messanordnung nach Anspruch 1, **dadurch gekennzeichnet, dass** das Messgerät (1) zum Ermitteln von elektrischer Spannung und elektrischem strom ausgelegt ist.

3. Messanordnung nach Anspruch 1 oder 2, **dadurch gekennzeichnet, dass** der Generator (3) derart leistungsarm ausgelegt ist, dass dem Messgerät (1) mittels eines Speisesignals (Uss) eine elektrische Leistung von höchstens 100 mW zuführbar ist.

4. Messanordnung nach einem der vorhergehenden Ansprüche, **dadurch gekennzeichnet, dass** die beiden Teilzweige (Z1, Z2) eng benachbart zueinander angeordnet sind.

5. Messanordnung nach einem der vorhergehenden Ansprüche, **dadurch gekennzeichnet, dass** die beiden Teilzweige (Z1, Z2) im Übertragungsglied (90) nebeneinander in einem Isolator (80) angeordnet sind.

6. Messanordnung nach einem der vorhergehenden Ansprüche, bei der das Speisesignal (Us, Us+, Us-, Uss) eine Speisefrequenz zwischen 1 kHz und 1 MHz aufweist.

7. Messanordnung nach einem der vorhergehenden Ansprüche, **dadurch gekennzeichnet, dass** eine zusätzliche, insbesondere optische, Übertragungsstrecke (2) zur Übertragung eines vom Messgerät (1) ermittelten Messsignals vorgesehen ist.

8. Messanordnung nach einem der vorhergehenden Ansprüche, **gekennzeichnet dadurch, dass** die mindestens zwei Spannungsteilermittel des jeweiligen Teilzweiges (Z1, Z2) mindestens zwei Kapazitäten (C1, C2, C3, C4) sind.

9. Messanordnung nach einem der Ansprüche 1 bis 7, **gekennzeichnet dadurch, dass** die mindestens zwei Spannungsteilermittel des jeweiligen Teilzweiges (Z1, Z2) mindestens zwei parallelschaltungen aus mindestens einer Kapazität (C1, C2, C3, C4) und mindestens einem Widerstand (R1, R2, R3, R4) sind.

## Claims

1. Measuring arrangement having an electrical measuring instrument (1), arranged at a high voltage potential, and having for the measuring instrument an energy-supplying arrangement which comprises the following parts, specifically at least:
- a first transformer (T1) on the ground potential side, which
- has a primary side to which a generator (3) for generating an energy-supplying feed signal (Us) is connected, and
- has a symmetrically subdivided secondary side,
- a second transformer (T2) on the high voltage potential side, which
- has a symmetrically subdivided primary side whose division point (K4) is at the high voltage potential, and
- has a secondary side to which the measuring instrument (1) is to be connected for the supply of energy,
and
- a symmetrically constructed potential-reducing transmission element (90), that
- has two parallel sub-branches (Z1 Z2) that run between the secondary side of the first transformer (T1) and the primary side of the second transformer (T2), and
- has in each case for the purpose of voltage division at least two voltage divider means (C1, C2, C3, C4, R1, R2, R3, R4) with an intermediate nodal point (K1, K2), **characterized in that**
- starting from the two nodal points (K1, K2) of the transmission element (90), two lines (E1, E2) are connected in an electrically combined fashion to the measuring instrument (1) for the purpose of voltage measurement between the high voltage potential and the nodal points (K1, K2), and **in that**
- the division point of the secondary side of the first, ground potential side transformer is at ground potential.

2. Measuring arrangement according to claim 1, **characterized in that** the measuring instrument (1) is designed for determining an electric voltage and an electric current.

3. Measuring arrangement according to claim 1 or 2, **characterized in that** the generator (3) is designed with low power in such a way that an electric power of at most 100 mW can be fed to the measuring instrument (1) by means of a feed signal (Uss).

4. Measuring arrangement according to one of the preceding claims, **characterized in that** the two sub-branches (Z1 Z2) are arranged closely neighboring one another.

5. Measuring arrangement according to one of the preceding claims, **characterized in that** the two sub-branches (Z1 Z2) in the transmission element (90) are arranged next to one another in an insulator (80).

6. Measuring arrangement according to one of the preceding claims, in which the feed signal (Us, Us+, Us-, Uss) has a feed frequency of between 1 kHz and 1 MHz.

7. Measuring arrangement according to one of the preceding claims, **characterized in that** an additional, in particular optical, transmission link (2) is provided for transmitting a measuring signal determined by the measuring instrument (1).

8. Measuring arrangement according to one of the preceding claims, **characterized in that** the at least two voltage divider means of the respective sub-branch (Z1 Z2) are at least two capacitors (C1, C2, C3, C4).

9. Measuring arrangement according to one of claims 1 to 7, **characterized in that** the at least two voltage divider means of the respective sub-branch (Z1 Z2) are at least two parallel circuits composed of at least one capacitor (C1, C2, C3, C4) and at least one resistor (R1, R2, R3, R4).

## Revendications

1. Dispositif de mesure ayant un appareil de mesure électrique (1) mis sur un potentiel de haute tension et un dispositif d'alimentation en énergie de l'appareil de mesure, lequel dispositif d'alimentation en énergie comprend les parties suivantes, à savoir au moins :
- un premier transformateur (T1), situé du côté du potentiel de terre, qui comporte
- un côté primaire auquel est raccordé un générateur (3) pour la production d'un signal d'alimentation (Us) réalisant l'alimentation en énergie, et
- un côté secondaire divisé symétriquement,
- un deuxième transformateur (T2), situé du côté du potentiel de haute tension, qui comporte
- un côté primaire, divisé symétriquement, dont le point de division (K4) est mis au potentiel de haute tension, et
- un côté secondaire auquel l'appareil de mesure (1) est à raccorder pour l'alimentation en énergie,
et
- un élément de transmission (90), de structure symétrique et réducteur de potentiel,
- qui comporte deux branches partielles parallèles (Z1 Z2), qui s'étendent entre le côté secondaire du premier transformateur (T1) et le côté primaire du deuxième transformateur (T2), et
- qui comportent chacune pour la division de tension au moins deux moyens diviseurs de tension (C1, C2, C3, C4, R1, R2, R3, R4) avec un noeud (K1, K2) entre ceux-ci,
**caractérisé par le fait que**
- à partir des deux noeuds (K1, K2) de l'élément de transmission (90), deux lignes (E1, E2) destinées à la mesure de tension sont reliées, réunies électriquement entre le potentiel de haute tension et les noeuds (K1, K2), à l'appareil de mesure (1), et que
- le point de division du côté secondaire du premier transformateur situé du côté du potentiel de terre est mis au potentiel de terre.

2. Dispositif de mesure selon la revendication 1, **caractérisé par le fait que** l'appareil de mesure (1) est conçu pour déterminer une tension électrique et un courant électrique.

3. Dispositif de mesure selon la revendication 1 ou 2, **caractérisé par le fait que** le générateur (3) est conçu de faible puissance de telle sorte qu'une puissance électrique maximale de 100 mW peut être envoyée au moyen d'un signal d'alimentation (Uss) à l'appareil de mesure (1).

4. Dispositif de mesure selon l'une des revendications précédentes, **caractérisé par le fait que** les deux branches partielles (Z1 Z2) sont disposées très près l'une de l'autre.

5. Dispositif de mesure selon l'une des revendications précédentes, **caractérisé par le fait que** les deux branches partielles (Z1 Z2) dans l'élément de transmission (90) sont disposées l'une à côté de l'autre dans un isolant (80).

6. Dispositif de mesure selon l'une des revendications précédentes, **caractérisé par le fait que** le signal d'alimentation (Us, Us +, Us -, Uss) a une fréquence d'alimentation comprise entre 1 kHz et 1 MHz.

7. Dispositif de mesure selon l'une des revendications précédentes, **caractérisé par le fait qu'**une voie de transmission supplémentaire (2), notamment optique, est prévue pour la transmission d'un signal mesuré déterminé par l'appareil de mesure (1).

8. Dispositif de mesure selon l'une des revendications précédentes, **caractérisé par le fait que** les au moins deux moyens diviseurs de tension de la branche partielle respective (Z1 Z2) sont au moins deux capacités (C1, C2, C3, C4).

9. Dispositif de mesure selon l'une des revendications 1 à 7, **caractérisé par le fait que** les au moins deux moyens diviseurs de tension de la branche partielle respective (Z1 Z2) sont au moins deux montages en parallèle composés d'au moins une capacité (C1, C2, C3, C4) et d'au moins une résistance (R1, R2, R3, R4).
